**Europäisches Patentamt**

**European Patent Office**

**Office européen des brevets**

(11) Veröffentlichungsnummer: **0 155 644**

**A2**

(12) # EUROPÄISCHE PATENTANMELDUNG

(21) Anmeldenummer: 85102972.8

(22) Anmeldetag: 14.03.85

(51) Int. Cl.⁴: **G 02 F 1/13**
G 02 F 1/133, G 02 F 3/00
G 06 F 7/56, G 09 G 3/36
G 11 C 13/04

(30) Priorität: 19.03.84 SE 8401504

(43) Veröffentlichungstag der Anmeldung:
25.09.85 Patentblatt 85/39

(84) Benannte Vertragsstaaten:
DE FR GB

(71) Anmelder: ASEA AB

S-721 83 Västeras(SE)

(72) Erfinder: Bijlenga, Bo, Dipl.-Ing.
Siggesborgsgatan 7C
S-722 26 Västeras(SE)

(72) Erfinder: Brogardh, Torgny, Prof.
Piatverksgatan 140
S-724 74 Västeras(SE)

(72) Erfinder: Malmhäll, Roger, Dr.
Hyacintvägen 73
S-722 43 Västeras(SE)

(74) Vertreter: Boecker, Joachim, Dr.-Ing.
Rathenauplatz 2-8
D-6000 Frankfurt a.M. 1(DE)

(54) Optoelektrische Anordnung für die Informationstechnologie.

(57) Optoelektrische Anordnung für die Informationstechnologie zur Erfassung, Registrierung, Verschiebung, Erzeugung und logischen Verarbeitung von optischen Information sowie zur Umwandlung von Information aus der optischen in elektrische Form und umgekehrt, mit Fotodetektoren, zum Beispiel Fotowiderständen, zur Erfassung der optischen Information und bistabilen Flüssigkeitskristallen zur Erzeugung und Verarbeitung der optischen Information, wobei der Flüssigkeitskristall zwischen zwei ebenen transparenten Scheiben angeordnet ist, die mit einem Elektrodenmuster versehen sind. Gemäß der Erfindung definiert das Elektrodenmuster modulierbare Bildelemente (6), die über mindestens einen Fotowiderstand (4) und eventuell einen Dünnfilmwiderstand (3) an Leiter (7,8) angeschlossen sind, die ihrerseits an Spannungsquellen (1,2) angeschlossen sind, welche die Spannung Null sowie positive und negative Spannungsimpulse abzugeben vermögen.

FIG. 2

EP 0 155 644 A2

12.3.1985
21 559 FE
0155644

ASEA AB
S-721 83 Västeras/Schweden

Optoelektrische Anordnung für die Informationstechnologie

Die vorliegende Erfindung betrifft eine optoelektrische Anordnung für die Informationstechnologie gemäß dem Oberbegriff des Anspruches 1.

Zur Eingabe, Verschiebung, Verarbeitung und Erzeugung von
optischen Informationen sind bereits Strukturen unter
Anwendung schneller, bistabiler Flüssigkeitskristalle
bekannt. Bei diesen Strukturen besteht jedoch das Problem,
daß einander kreuzende elektrische Dünnfilmleiter vorkommen,
und man lichtpolarisierende Schichten innerhalb des Modulators anbringen muß. Hierdurch werden die bekannten Strukturen sehr kompliziert.

Der Erfindung liegt die Aufgabe zugrunde elektrooptische Modulatoren der eingangs genannten Art zu entwickeln, die von
den genannten Nachteilen der bekannten Modulatoren befreit
sind.

Zur Lösung dieser Aufgabe wird eine optoelektrische Anordnung gemäß dem Oberbegriff des Anspruches 1 vorgeschlagen,
welche erfindungsgemäß die im kennzeichnenden Teil des Anspruches 1 genannten Merkmale hat.

Vorteilhafte Ausgestaltungen der Erfindung sind in den weiteren Ansprüchen genannt.

Die Modulatoren bei der Anordnung gemäß der Erfindung enthalten keine einander kreuzenden elektrischen Dünnfilmleiter, und lichtpolarisierende Schichten können vollständig außerhalb des Modulators angebracht werden. Die Modulatoren gemäß der Erfindung sind besonders geeignet zum Messen, zur Bildverarbeitung und zur Kommunikation zwischen Mensch und Maschine.

Die vorliegende Erfindung betrifft also eine Anordnung zur Erfassung und Registrierung von Informationen in optischer oder elektrischer Form, zur Umwandlung von Informationen aus der elektrischen in die optische Form und/oder umgekehrt, zur Ausführung verschiedener Funktionen und zur Verarbeitung der registrierten Informationen mit Hilfe optischer und elektrischer Signale, wobei die optischen Informationen von einer in einer, zwei- oder drei Raumkoordinaten zeitlich variierenden Lichtintensität und/oder Lichtpolarisation und/oder spektralen Zusammensetzung gebildet werden. Bei den einzelnen Funktionen kann es sich um die logischen Verknüpfungsfunktionen AND, OR und/oder NOT handeln, wobei die Erfassung, Registrierung, Umwandlung und Verarbeitung von Informationen in optischer oder elektrischer Form durch optische Modulatoren, zum Beispiel von der Art smectic C$^*$, aufgebaut sind, d.h. aus Flüssigkeitskristallen mit bistabiler Eigenschaft in Verbindung mit Fotodetektoren, wie zum Beispiel Fotowiderständen.

In der EP-A-82102442.9 wird eine Anordnung zur Adressierung von flachen Displays beschrieben, die im wesentlichen auf dem Flüssigkeitskristallprinzip aufgebaut sind. Bei der Anordnung nach dieser Druckschrift erfolgen Eingabe, Ausgabe und Verschiebung von Informationen in einer, zwei oder drei Raumkoordinaten durch Verwendung elektrooptisch rückgekoppelter Kreise, die untereinander optoelektrisch zu elektrooptischen Schieberegistern verbunden sind. Die Informationen werden in Speicherelementen gespeichert, die durch

12.3.1985
21 559 PE
0155644

elektrooptische Rückkopplung ein sicheres bistabiles Verhalten haben. Weitere Anwendungsbereiche dieser und ähnlicher elektrooptisch rückgekoppelter Kreise sind in der DE-OS 3237850 beschrieben, die sich auf optoelektronische Bildprozessoren bezieht. Hier werden die Aufteilungs- und Gradientenbildüngsfunktionen der elektrooptischen Modulatoren beschrieben.

In der EP-A-83100199.5 werden elektrisch und/oder optisch gesteuerte Schieberegister mit bistabilen optischen Modulatoren beschrieben. Im Vergleich zu dem in den vorgenannten Druckschriften beschriebenen Modulatoren erhält man hierdurch erheblich einfachere und schnellere Funktionen. Diese letztgenannte Lösung gründet sich auf Flüssigkeitskristalle mit diesen immanten Hysterese-Effekten, die in jüngster Zeit experimentell nachgewiesen wurden (siehe z.B. N.A. Clark und S.T. Lagerwall, "Submicrosecond bistable electro-optic switching in liquid crystals", Applied Physics Letters, Vol. 36, No. 11, Seiten 899-901, vom 1. Juni 1980).

Die in der vorliegenden Erfindung beschriebenen elektrooptischen Modulatoren basieren auf bistabilen Flüssigkeitskristallen, die zur Erfassung und Registrierung von Informationen in elektrischer oder optischer Form zur Umwandlung von Informationen aus der optischen in die elektrische Form und/oder umgekehrt und zur Durchführung verschiedener Funktionen und zur Verarbeitung der registrierten Informationen verwendet werden. Zum Unterschied von den oben genannten Druckschriften können optische Bilder sowohl in normaler wie umgekehrter Form eingegeben werden, und es können verschiedene logische Funktionen, wie z.B. AND, OR, und NOT, mit den registrierten optischen Informationen durchgeführt werden. Die Erfindung ermöglicht auch einen bedeutend einfacheren Aufbau der elektrooptischen Modulatoren, da die Polarisatoren auf der Außenseite der Modulatoren angebracht werden können, nur zwei elektrische Leiter für sämtliche Bildelemente erforderlich sind und eine optische Verschiebung der Informationen ohne irgendwelche optoelektrischen Verbindungen benachbarter Bildelemente vorgenommen werden kann.

Bei der Erfindung bestehen die elektrooptischen Modulatoren aus einem Material mit einer innewohnenden Hysterese der Lichttransmission als Funktion der Modulatorspannung. Der Modulator befindet sich in demselben Strahlengang einer Lichtquelle wie die an den Modulator elektrisch angeschlossenen Fotodetektoren, und die Modulatoren sind auf der einen Seite mit einer von den übrigen Modulatorelektroden isolierten Elektrode versehen, welche die seitliche Ausdehnung des Modulators bestimmt.

Anhand der in den Figuren gezeigten Ausführungsbeispiele soll die Erfindung näher erläutert werden. Es zeigen

Figur 1 den Zusammenhang zwischen der Lichttransmission und der Modulatorspannung für Flüssigkeitskristallzelle, wie sie für die Modulatorelemente bei der Erfindung verwendet werden,

Figur 2 die elektrische Grundschaltung von Modulator-/Bildelementen in der Anordnung gemäß der Erfindung,

Figur 3a den räumliche Aufbau eines Modulatorelementes in einer Anordnung gemäß der Erfindung von oben gesehen,

Figur 3b das Modulatorelement gemäß Figur 3a im Schnitt längs der Linie A-A,

Figur 4a und 4b zeigen ein Ausführungsbeispiel einer aus einer Vielzahl von Modulatorelementen zusammengesetzten Modulatormatrize,

12.3.1985
21 559 PE
0155644

Figur 5 ein Ausführungsbeispiel einer Anordnung nach der Erfindung mit zwei Modulatoren zur Ausführung einer Mehrstufigen Operation,

Figur 6 dient zur Erläuterung einer mehrstufigen Operation.

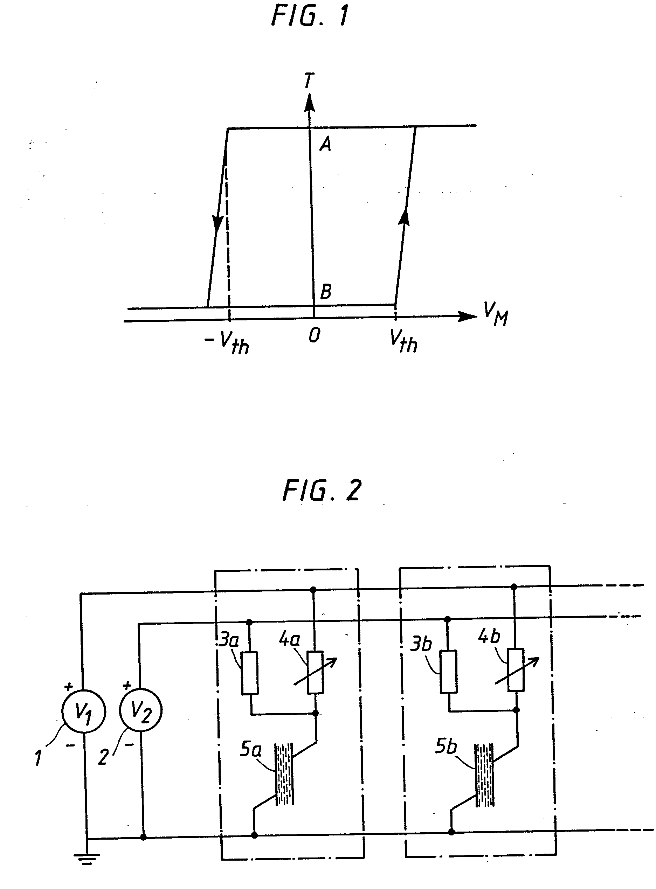

Figur 1 zeigt eine typische Hysteresekurve für eine bistabile Flüssigkeitskristallzelle nach Clark u.a. ("Terroelectric liquid crystal electro-optics using the surface stabilized structure", Molecule Crystals and Liquid Crystals, Vol. 94, Seiten 213 - 34, 1983), wobei auf der X-Achse die Modulatorspannung $V_M$ und auf der Y-Achse die Lichttransmission T aufgetragen ist. Bei der Modulatorspannung Null hat der Modulator zwei stabile Transmissionszustände A und B, wobei im Transmissionszustand A die Lichttransmission groß und im Transmissionszustand B die Lichttransmission klein ist. Aus dem Transmissionszustand A kann der Modulator durch einen kurzen Spannungsimpuls, dessen Amplitude mindestens $-V_{th}$ betragen muß, in den Transmissionszustand B gekippt werden und aus diesem durch einen Spannungsimpuls mit der Mindestgröße $+V_{th}$ in den Transmissionszustand A gekippt werden.

Spannungsimpulse mit Amplituden, die größer als $-V_{th}$ und kleiner als $+V_{th}$ sind, können den bestehenden Transmissionszustand des Modulators nicht verändern.

Figur 2 zeigt die eleketrische Grundschaltung von Modulator-/Bildelementen bei der vorliegenden Erfindung. Zwei Spannungsquellen 1 und 2 sind an die Fotowiderstände 4a und 4b bzw. an die Widerstände 3a und 3b sämtlicher Modulatorelemente angeschlossen, wobei in Figur 2 nur zwei Elemente dargestellt sind. Die Fotowiderstände 4a und 4b und die Widerstände 3a und 3b sind an die bistabilen Flüssigkeitskristallzellen 5a und 5b angeschlossen, die eine Transmissionscharakteristik gemäß Figur 1 haben.

Durch geeignete Wahl der von den Spannungsquellen 1 und 2 gelieferten Spannungsimpulse $V_1$ und $V_2$ kann man verschiedene Transmissionszustände A und B an den Modulatoren einstellen, was davon abhängt, ob der zugehörige Fotowiderstand 4 Licht empfängt oder nicht. Hierbei kann man eine Anzahl verschiedener Fälle unterscheiden in Abhängigkeit davon, ob $V_1$ einen positiven Impuls, einen negativen Impuls oder keinen Impuls liefert, wobei diese drei Möglichkeiten mit den drei Möglichkeiten kombiniert werden können, daß $V_2$ einen positiven Impuls, einen negativen Impuls oder keinen Impuls liefert. Die Amplituden der Impulse haben optimale Werte im Hinblick darauf, welche Widerstandswerte der Fotowiderstand 4 im beleuchteten ($R_{on}$) bzw. im nicht beleuchteten ($R_{off}$) Zustand im Verhältnis zu dem Wert $R_o$ für den Widerstand 3 annimmt. Unter der Voraussetzung, daß $R_{on} \ll R_o$ und $R_{off} \gg R_o$, können folgende Fälle unterschieden werden:

1. $V_1 = V_{th}$, $V_2 = -V_{th}$; alle beleuchteten Modulatorelemente nehmen den hohen Transmissionszustand A, und alle nicht beleuchteten Modulatorelemente nehmen den niedrigen Transmissionszustand B ein. Dies entspricht einer binären Registrierung und Speicherung der empfangenen optischen Information in dem Modulator durch verschiedene Transmissionszustände A und B.

2. $V_1 = 0$, $V_2 = -V_{th}$; alle nicht beleuchteten Modulatorelemente nehmen den niedrigen Transmissionszustand B ein, und alle beleuchteten Modulatorelemente behalten ihre früheren Zustände A oder B bei. Dies entspricht der logischen Operatin AND zwischen der empfangenen optischen Information und der vorher in dem Modulator gespeicherten Information.

3. $V_1 = V_{th}$, $V_2 = 0$; alle beleuchteten Modulatorelemente nehmen den hohen Transmissionszustand A ein, und alle nicht beleuchteten Modulatorelemente behalten ihre früheren Zu-

12.3.1985
21 559 PE
0155644

stände A oder B bei. Dies entspricht der logischen Operation OR zwischen der empfangenen optischen Information und der vorher in dem Modulator gespeicherten Information.

4. $V_1 = -V_{th}$, $V_2 = V_{th}$; alle beleuchteten Modulatorelemente nehmen den niedrigen Transmissionszustand B, und alle nicht beleuchteten Modulatorelemente nehmen den hohen Transmissionszustand A ein. Dies entspricht der logischen Operation NOT (Negation) bezüglich der empfangenen optischen Information, da die Transmissionszustände im Vergleich zu dem Fall 1) vertauscht werden.

5. $V_1 = 0$, $V_2 = V_{th}$; alle nicht beleuchteten Modulatorelemente nehmen den Zustand A ein, und alle beleuchteten Modulatorelemente behalten ihren bisherigen Zustand bei. Dies entspricht der logischen Operation NAND zwischen der empfangenen optischen Information und der umgekehrten Version der vorher in dem Modulator gespeicherten Information.

6. $V_1 = -V_{th}$, $V_2 = 0$; alle beleuchteten Modulatorelemente nehmen den Zustand B ein, und alle nicht beleuchteten Modulatorelemente behalten ihren bisherigen Zustand bei. Dies entspricht der logischen Operation NOR zwischen der empfangenen optischen Information und der umgekehrten Version der vorher in dem Modulator gespeicherten Information.

7. $V_1 = V_{th}$, $V_2 = V_{th}$; alle Modulatorelemente nehmen den Transmissionszustand A ein.

8. $V_1 = -V_{th}$, $V_2 = V_{th}$; alle Modulatorelemente nehmen den Transmissionszustand B ein.

Bei anderen Relationen zwischen den Widerstandswerten des Fotowiderstandes 4 und des Widerstandes 3 gelten andere

12.3.1985
21 559 PE
0155644

Forderungen für die Amplituden der Spannungsimpulse $V_1$ und $V_2$. Wenn beispielsweise $R_{on} = 0,33\ R_o$ und $R_{off} = 3R_o$, dann muß die Amplitude $2V_{th}$ statt $V_{th}$ betragen.

Dadurch, daß man die Amplitude der Spannungsimpulse $V_1$ und $V_2$ und/oder den Wert des Widerstandes 3 variiert, wobei der Widerstand 3 auch ein Fotowiderstand sein kann, dessen Widerstandswert von Licht gesteuert wird, das nicht zur optischen Information gehört, kann das zur Aktivieren (Triggern) der einzelenen logischen Operationen nötige Lichtniveau gesteuert werden, d.h. eine Aufteilungs-Funktion (slicing-Funktion) gewonnnen werden.

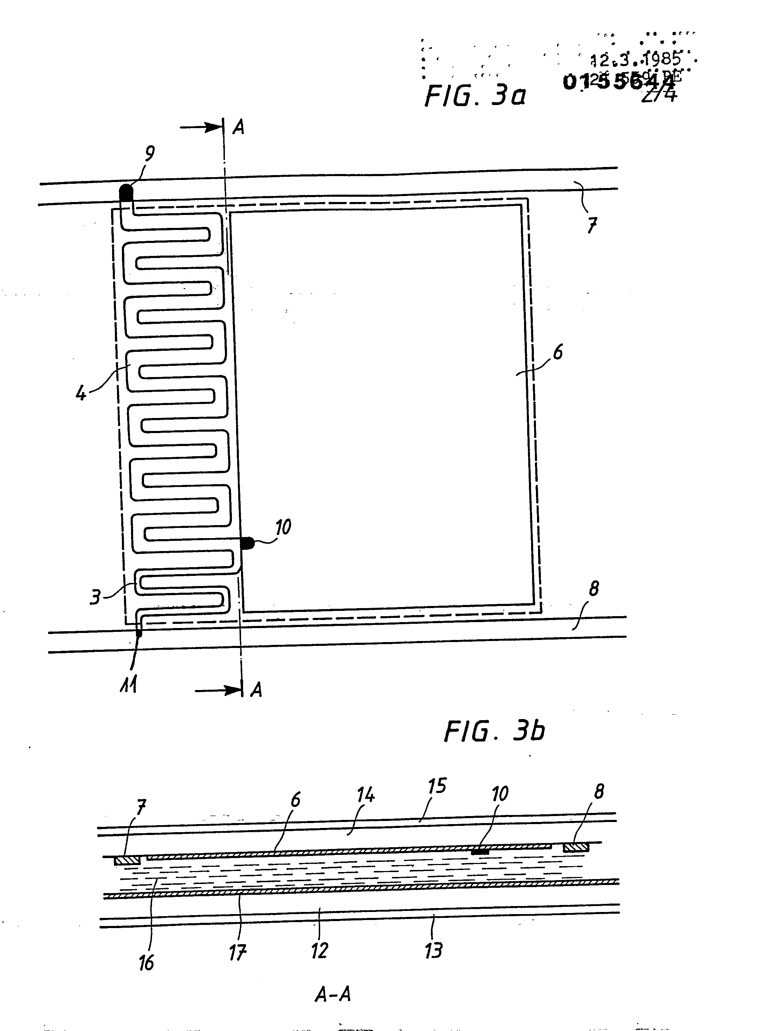

Figur 3a zeigt eine mögliche Realisierung eines Modulatorelements gemäß Figur 2, wenn der optische Modulator ein bistabiler Flüssigkeitskristall und das fotoempfindliche Teil ein Fotowiderstand ist. Figur 3b zeigt das Modulatorelement im Schnitt längs der Linie A-A in Figur 3a. Der Fotowiderstand 4 und der Dünnfilmwiderstand 3 sind in Reihe geschaltet und in den Kontaktpunkten 9 bzw. 11 an die elektrischen Leiter 7 bzw. 8 angeschlossen. Der Punkt zwischen dem Fotowiderstand 4 und dem Widerstand 3 ist in dem Kontaktpunkt 10 an eine transparente Elektrode 6 angeschlossen. Die Elektrode 6 bestimmt die seitliche Ausdehnung des optisch modulierenden Teils Modulatorelementes. Die Bauteile sind auf der Unterseite der oberen Glasplatte 14 in Figur 3b angeordnet. Die untere Glasplatte 12 hat eine transparente Elektrode 17, und zwischen den beiden Glasplatten 12 und 14 befindet sich ein Flüssigkeitskristall 16. Figur 3b zeigt ferner zwei polarisierende Schichten 13 und 15 an den Außenseiten des Modulatorelements, die in geeigneter Weise derart orientiert sind, daß das Modulatorelement einen ersten Zustand mit geringer und einen zweiten Zustand mit hoher Lichttransmission hat.

12.3.1985
21 559 PF
0155644

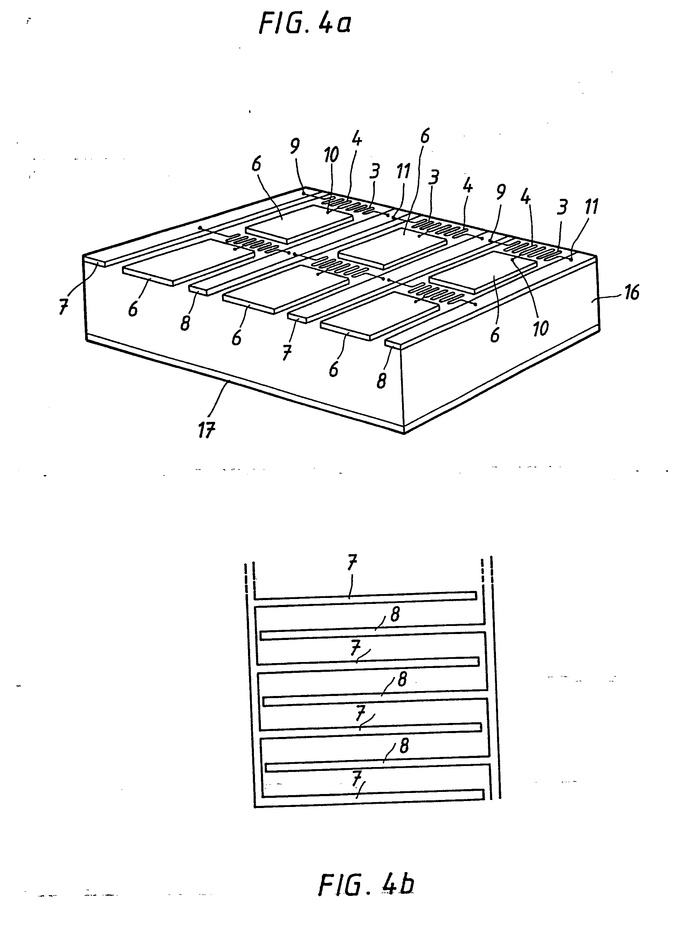

Das Modulatorelement nach Figur 2 und 3 kann mit weiteren Modulatorelementen zu einer ein- oder zweidimensionalen Matrize verbunden werden, wobei die Elektrode 17 die gesamte untere Glasplatte 12 bedeckt und für alle Modulatorelemente gemeinsam ist. Auf der oberen Glasplatte 12 sind für jedes Modulatorelement je eine Elektrode 6, ein Fotowiderstand 4 und ein Widerstand 3 vorhanden. Zwischen den Modulatorelementen sind elektrische Leiter 7,8 vohanden, die in einem fingerförmigen Muster nach Figur 4 ohne einander kreuzende Leiter angeordnet sind. Für die Modulatormatrize sind nur drei äußere elektrische Anschlüsse erforderlich, wobei die Spannungsquelle 1 an den Leiter 7, die Spannungsquelle 2 an den Leiter 8 und die völlig abdeckende Elektrode 17 an den gemeinsamen Punkt zwischen den Spannungsquellen 1 und 2 angeschlossen ist.

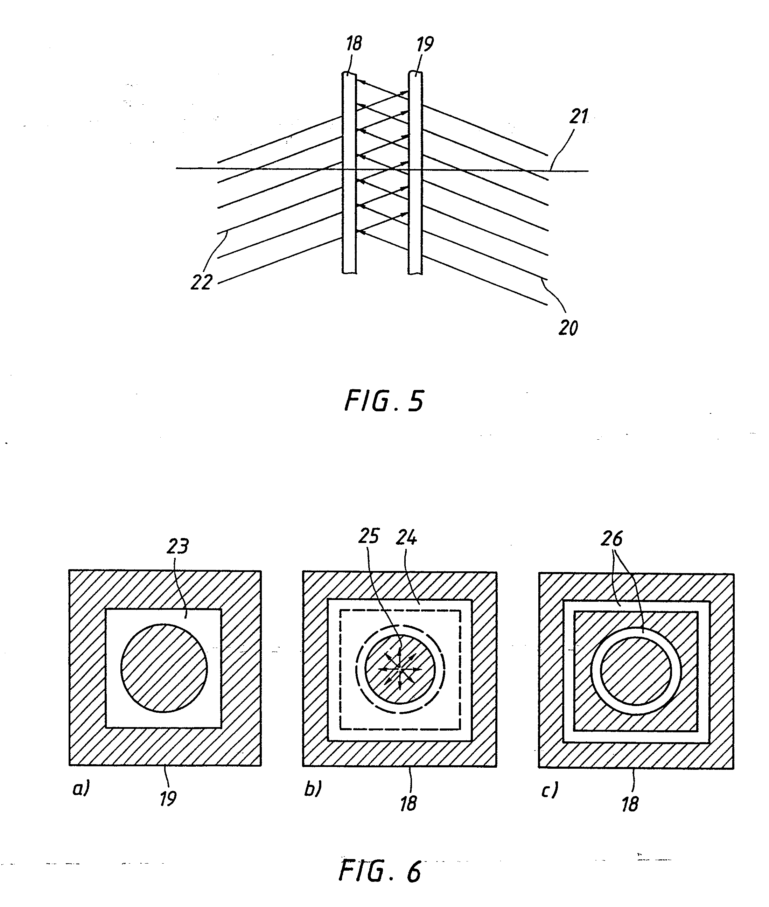

Elektrooptische Modulatoren, die gemäß Figur 2 bis 4 aufgebaut sind, können beispielsweise paarweise kombiniert werden, um mehrstufige Operationen auszuführen, wie zum Beispiel die Verschiebung registrierter optischer Informationen in beliebiger Richtung in den Ebenen der Modulatoren. Eine solche Verschiebung wird anhand der Figur 5 beschrieben, in der die elektrooptischen Modulatoren 18 und 19 von der Seite sichtbar sind. Optische Informationen werden in einer 1. Phase auf dem Modulator 19 abgebildet, der ein Transmissionsmuster hat, welches der seitlichen Verteilung des einfallenden Lichtes hier unter Aktivierung gemäß dem oben beschriebenen Fall 1 entspricht. In der 2. Phase wird das Transmissionsmuster des Modulators 19 auf dem Modulator 18 durch ein paralleles Strahlenbündel 20 einer Lichtquelle abgebildet, die außerhalb der optischen Achse 21 des Systems angeordnet ist. Der Modulator 18 wird hier gemäß dem oben beschriebenen Fall 1 aktiviert. Dadurch erhält man auf dem Modulator 18 das gleiche Transmissionsmuster wie auf dem Modulator 19, jedoch verschoben im Verhältnis zur opitschen Achse, was mit einer Verschiebung nach oben in Figur 5

12.3.1985
21 559 FE
0155644

exemplifiziert ist. In der 3. Phase kann der Zustand des Modulators 18 mit Hilfe eines anderen parallelen Strahlenbündels 22 auf dem Modulator 19 abgebildet werden. Wiederholte Abbildungen der vorgenannten Art bewirken eine stufenweise Verschiebung der registrierten optischen Information in beliebiger Richtung, was mit der Einfallsrichtung des parallelen Lichtes zusammenhängt. Diese Funktion kann zum Beispiel angewendet werden beim elektrischen Speichern/Auslesen von Bildern in/aus dem elektrooptischen Modulator, wobei elektrische Anschlüsse nur an einer Reihe von Modulatorelementen/Bildelementen an der Peripherie des Modulators erforderlich sind. Ein anderes Anwendungsbeispiel ist die optische Verarbeitungen von Informationen, bei der eine Verschiebung von Bildern erforderlich ist, um eine maximale Korrelation zu erreichen.

Dadurch, daß durch die vorliegende Erfindung mit Informationen, die in optischer Form vorliegen, die Operationen AND, OR, NOT, NAND und NOR ausgeführt werden können, lassen sich durch Kombination der genannten logischen Beziehungen auch andere logische Operationen aufbauen. Bei der optischen Bildverarbeitung ist es beispielsweise von großer Bedeutung, die Konturen eines abgebildeten Objektes schnell extrahieren zu können, was dadurch geschehen kann, daß man die logische Funktion XOR (exclusive-or) zwischen der vorliegenden Abbildung des Objektes und einem seitlich etwas verschobenen Bild desselben Objektes bildet. Die EXCLUSIVE-OR Operation kann zum Beispiel durch Kombination der logischen Funktionen AND, OR und NAND gebildet werden und kann deshalb mit den genannten elektrooptischen Modulatoren durchgeführt werden. So kann eine konturenextrahierende Anordnung gemäß Figur 5 mit zwei Modulatoren aufgebaut werden. Diese Anordnung kann die Konturen des abgebildeten Gegenstandes in drei Schritten berechnen, was in Figur 6 dargestellt ist.

a) Der Gegenstand wird in dem Modulator 19 unter Aktivierung gemäß dem oben beschriebenen Fall 1 registriert, wobei auf dem Modulator 19 das Transmissionsbild 23 erzeugt wird.

b) Das Bild 23 wird auf dem Modulator 18 unter Aktivierung des Modulators 18 gemäß dem oben beschriebenen Fall 1 mittels paralleler Lichtstrahlen 20 abgebildet, die von Lichtquellen herrühren, die auf einem konzentrischen Kreis um die optische Achse 21 herum plaziert sind, so daß das auf dem Modulator 18 gewonnene Transmissionsbild 24 eine Verschiebung des ursprünglichen Bildes 23 in mindestens acht Richtungen entspricht, was durch die Pfeile 25 in Figur 6b angedeutet ist.

c) Der Gegenstand wird erneut abgebildet. Diesmal jedoch auf dem Modulator 18 unter Aktivierung gemäß dem oben beschriebenen Fall 6, wodurch man das Transmissionsbild 26 erhält, und stellt die Konturen in dem ursprünglichen Bild 23 dar.

Die beschriebene Schaltung von elektrooptischen Modulatoren können in vielen verschiedenen Arten kombiniert werden, um andere Funktionen zum Beispiel andere logische Funktionen, eine Display-Funktion, eine Digitizerfunktion usw. zu erhalten, indem man zum Beispiel andere Arten von optischen Modulatoren und/oder andere Arten von Fododetektoren verwendet.

Die Erfindung kann im Rahmen des offenbarten allgemeinen Erfindungsgedanken in vielfacher Weise variiert werden.

12.3.1985
21 559 PE
0155644

## Patentansprüche

1. Optoelektrische Anordnung für die Informationstechnologie zur Erfassung, Registrierung, Verschiebung, Erzeugung und logischen Verarbeitung von optischen Information sowie zur Umwandlung von Information aus der optischen in elektrische Form und umgekehrt, mit Fotodetektoren, zum Beispiel Fotowiderständen, zur Erfassung der optischen Information und bistabilen Flüssigkeitskristallen, beispielsweise der Art smectic $C^*$, zur Erzeugung und Verarbeitung der optischen Information, wobei der Flüssigkeitskristall zwischen zwei ebenen transparenten Scheiben angeordnet ist, die mit einem Elektrodenmuster versehen sind, d a d u r c h g e - k e n n z e i c h n e t, daß das Elektrodenmuster modulierbare Bildelemente (6) definiert, die über mindestens einen Fotowiderstand (4) und eventuell einen Dünnfilmwiderstand (3) an Leiter (7,8) angeschlossen sind, die ihrerseits an Spannungsquellen (1,2) angeschlossen sind, welche die Spannung Null sowie positive und negative Spannungsimpulse abzugeben vermögen.

2. Optoelektrische Anordnung nach Anspruch 1, d a - d u r c h g e k e n n z e i c h n e t, daß das Elektrodenmuster (17) auf der einen Seite der Flüssigkeitskristallschicht (16) einen niederohmigen elektrischen Kontakt mit allen Bildelementen (6) bildet, daß das Elektrodenmuster auf der anderen Seite des Flüssigkeitskristalls aus Bildelementen entsprechenden Inseln (6) und den Leitern (7, 8) entsprechenden Bändern besteht und daß die Bänder (7, 8) ein doppeltes Gabelmuster (Figur 4b) bilden, bei dem sich die Anschlüsse der Inseln (6) an die Bänder (7, 8) nicht gegenseitig kreuzen.

3. Optoelektrische Anordnung nach Anspruch 2, d a - d u r c h g e k e n n z e i c h n e t, daß das Elektrodenmuster (17) auf der einen Seite der Flüssigkeitskristall-

12.3.1985
21 559 PE
0155644

schicht (16) an die beiden Spannungsquellen (1, 2) angeschlossen ist und daß das eine Gabelmuster (7) auf der einen Seite der Flüssigkeitskristallschicht (17) an die Spannungsquelle 1 und das andere Gabelmuster (8) an die Spannungsquelle (2) angeschlossen ist.

4. Optoelektrische Anordnung nach Anspruch 1, d a - d u r c h  g e k e n n z e i c h n e t , daß die Spannungsquellen verschiedene Kombinationen von Ausgangsspannungszuständen ($V_1$, $V_2$) zur Durchführung verschiedener Operationen mit den optischen Informationen erzeugen, wie zum Beispiel Registrierung, Speicherung oder logische Verknüpfungen.

5. Optoelektrische Anordnung nach Anspruch 4, d a - d u r c h  g e k e n n z e i c h n e t , daß die Spannungszustände $V_1$ = positiver Impuls und $V_2$ = negativer Impuls eine binäre Registrierung und Speicherung der empfangenen 2-dimensionalen Information bewirken, daß die Spannungszustände $V_1$ = 0 und $V_2$ = negativer Impuls eine AND-Operation zwischen empfangener und gespeicherter Information bewirken, daß die Spannungszustände $V_1$ = positiver Impuls und $V_2$ = 0 eine OR-Operation bewirken, daß die Spannungszustände $V_1$ = negativer Impuls und $V_2$ = positiver Impuls eine Negation der empfangeenn optischen Information bewirken, daß die Spannungszustände $V_1$ = 0 und $V_2$ = positiver Impuls eine NAND-Operation bewirken, daß die Spannungszustände $V_1$ = negativer Impuls und $V_2$ = 0 eine NOR Operation bewirken, daß die Spannungszustände $V_1$ = positiver Impuls und $V_2$ = positiver Impuls alle Bildelemente auf Eins stellen, und daß die Spannungszustände $V_1$ = negativer Impuls und $V_2$ = negativer Impuls alle Bildelmente auf 0 stellen, wobei eine 1 einem im Vergleich zu einer 0 hohen Transmissionswert entspricht.

6. Optoelektrische Anordnung nach Anspruch 2, d a - d u r c h  g e k e n n z e i c h n e t , daß die genannten

12.3.1985
21 559 PE
0155644

Inseln über Dünnfilmfotowiderstände (4) an das Band (7) des einen Gabelmusters und über Dünnfilmwiderstände (3) an das Band (8) des anderen Gabelmusters angeschlossen sind.

7. Optoelektrische Anordnung nach Anspruch 6, d a - d u r c h   g e k e n n z e i c h n e t, daß anstelle des Dünnfilmwiderstand (3) ein Dünnfilmfotowiderstand vorhanden ist und daß der Widerstandswert des Fotowiderstands von einer separaten Lichtquelle oder einer anderen Lichtinformation zur Regelung des Aktivierungsniveaus der Bildelemente steuerbar ist, wodurch die Operation Aufteilung (slicing) und Korrelation in zwei Dimensionen zustandekommen.

8. Optoelektrische Anordnung nach einem der vorhergehenden Ansprüche, d a d u r c h   g e k e n n z e i c h n e t, daß zwei oder mehrere Modulatoren (18, 19) in einem optischen System für verschiedene Arten von Abbildungen auf den Modulatoren derart übereinander angeordnet sind, daß die optischen Informationen verschoben, expandiert, komprimiert, gradientengebildet, usw. werden können.

9. Optoelektrische Anordnung nach Anspruch 8, d a - d u r c h   g e k e n n z e i c h n e t, daß zwei Modulatoren (18, 19) paarweise plaziert sind und daß die Information der Modulatoren durch parallele zur Oberfläche senkrecht oder schräg verlaufende Strahlenbündel oder durch divergierende oder konvergierende Strahlenbündel von dem einen auf den anderen Modulator übertragen werden.

10. Optoelektrische Anordnung nach Anspruch 8, d a - - d u r c h   g e k e n n z e i c h n e t, daß die Bildelemente an ein Elektroniksystem zum direkten elektrischen Speichern von Informationen in den Modulatorelementen elektrisch angeschlossen sind.

FIG. 1

FIG. 2

FIG. 3a

12.3.1985
0155644
2/4

FIG. 3b

A-A

FIG. 4a

FIG. 4b

FIG. 5

FIG. 6